# EUROPEAN PATENT APPLICATION

(11) **EP 0 852 223 A1**
(43) Date of publication of application: **08.07.1998**
(21) Application number: 96830607.6
(22) Date of filing: 04.12.1996
(51) Int. Cl.: C04B 41/85, C23C 16/40

(54) **Method of sealing open-pore ceramic coatings, in particular thermal barriers**

(71) Applicant: European Atomic Energy Community ( Euratom), 2920 Luxembourg (LU)
(72) Inventor: The designation of the inventor has not yet been filed
(74) Representative: Plebani, Rinaldo

(57) **Abstract**

A method of sealing open-pore ceramic coatings, in particular thermal barrier coatings, whereby a sealer is deposited from a metallorganic precursor by chemical vapor deposition on to the outer surface of the coatings; the chemical vapor deposition being so controlled as to limit the penetration depth of the sealer inside the pores of the coatings to a predetermined value preferably ranging between approximately 10 µm and approximately 20 µm. The sealer used is silica, SiO₂, obtained from a precursor of tetraethylorthosilicate (TEOS), Si(OC₂H₅)₄; and chemical vapor deposition is performed at a temperature of 700°C and a total pressure of 200 Pa, in a horizontal-hot-wall reactor having a quartz tube heated by a conventional oven, and in the presence of oxygen and nitrogen.

## Description

The present invention relates to a method of sealing open-pore ceramic coatings, and which is especially suitable for sealing thermal barriers, e.g. of the plasma sprayed type used for protecting gas turbine components.

As is known, to increase operating temperature and efficiency, certain gas turbine components, normally made of special metal alloys, are applied with what are commonly known as thermal barrier coatings (TBC), which comprise porous ceramic coatings and, by virtue of their insulating properties, provide for an increase in temperature between the outer surface of the coating and the base material of the component. TBCs are normally formed of zirconium oxide which is plasma sprayed on to metal turbine components, and efficiency is in direct proportion to the porosity of the ceramic coating, so as to ensure maximum thermal insulation. On the other hand, the open porosity typical of this type of coating allows the corrosive gases normally present inside turbines to circulate inside the thermal barrier up to the ceramic-metal interface, thus resulting in corrosion and detachment of the coating.

One solution to the problem would be to surface seal the ceramic coating to only close the openings of the pores facing the aggressive environment, as opposed to closing the pores entirely, which would impair the insulation efficiency of the coating.

Such a solution is known to have been attempted by remelting the surface of the ceramic coating using a laser. In addition to being expensive, however, this method is also difficult to actually put into practice, in that, unless great care is taken, it produces grooves and cracks in the coating of much the same size as the pores, thus defeating the object of the process.

It is an object of the present invention to provide an effective, straightforward, low-cost method of surface sealing open-pore ceramic coatings.

According to the present invention, there is provided a method of sealing open-pore ceramic coatings, in particular thermal barrier coatings, the method comprising a deposition step wherein a sealer is deposited on the outer surface of said coatings; characterized in that said deposition step is performed by chemical vapor deposition (CVD) of said sealer on said outer surface of said coatings; said chemical vapor deposition being so controlled as to limit the penetration depth of said sealer inside the pores of said coatings to a predetermined value.

More specifically, the penetration depth of said sealer inside said pores ranges between approximately 10 µm and approximately 20 µm.

The chemical vapor deposition step is performed using a metallorganic precursor of said sealer. According to a preferred embodiment, said sealer is silicon dioxide (silica), SiO₂, and said metallorganic precursor of said sealer is tetraethylorthosilicate (TEOS), Si(OC₂H₅)₄.

In the method according to the present invention, the chemical vapor deposition step from said metallorganic precursor is performed in a horizontal-hot-wall reactor comprising at least one quartz tube heated by a conventional oven; and deposition is preferably performed at a temperature of 700°C, at a total pressure of 200 Pa, and in the presence of oxygen and nitrogen.

The oxygen is fed into the reactor at a flow rate of 10 cm³/min; and the nitrogen is used partly as an inert gas to transport the metallorganic precursor at a flow rate of 10 cm³/min, and partly as a diluting gas at a flow rate of 100 cm³/min.

Using the method according to the present invention, it is surprisingly possible to only surface seal the pores of TBCs (to a depth of about 10 µm), thus preventing the passage of corrosive fluids with substantially no change in the conductivity of the barrier, and, consequently increasing the resistance to aggressive atmospheres and the working life of the coated components, even when using poor fuel.

Though commonly used in electronic applications, chemical vapor deposition (CVD) has never before been applied to the sealing of porous coatings in general, and TBCs in particular, and is particularly ideal for this type of application by providing for a high degree of penetration, and the formation of high-quality coatings - with precise control of the deposition process - on components of different, even complex, shapes and sizes.

Moreover, the metallorganic precursor preferably employed - TEOS - is easy to procure, inexpensive, easy to use, and active within a wide range of temperatures.

Finally, the silica produced is amorphous, thus ensuring a fair degree of compatibility with the zirconium oxide of the TBCs, and low permeability in relation to oxygen and corrosive gases.

A non-limiting embodiment of the present invention will be described by way of example with reference to the accompanying drawings, in which:
Figure 1 shows an infrared reflection spectrum of silica sealing coatings formed using the method according to the invention;
Figure 2 shows surface micrographs, obtained using a scanning electron microscope (SEM), of (a) a thermal barrier prior to sealing; and (b) a thermal barrier sealed with a CVD silica coating;
Figure 3 shows the structure and silicon line-scan analysis of a cross section of a silica-coated specimen;
Figure 4 shows the results of porosity measurements of non-sealed specimens (dotted-line curve) and sealed specimens (continuous-line curve), and represents the volume (in mm³/g) of mercury accumulated as a function of the pressure (in bars) at which the measurement was made;
Figure 5 shows the relative volume (expressed as a percentage) as a function of the radius (expressed in microns) of the pores, calculated from the porosity measurements;
Figure 6 shows the results of high-temperature oxidation tests of non-sealed specimens (dotted-line curve) and sealed specimens (continuous-line curve), and represents the variation in weight (in mg/cm²) of the specimen as a function of oxidation time (in hours).

### EXAMPLE

Specimens of a typical base material used for making gas turbine components, in particular impeller blades, were plasma sprayed with a known thermal barrier coating; some of the specimens were subjected to the TBC sealing process according to the invention; and all the specimens, sealed and non-sealed, were high-temperature oxidation tested to determine the efficiency of the sealed as compared with the non-sealed barriers.

A nickel superalloy known as UD 520 was used as the base material; and a study was made of 5 mm diameter, 30 mm high cylindrical specimens.

### 1. Formation of thermal barrier coatings (TBCs): plasma spray technique

Following electroerosion, activation by sanding, and vacuum heat treatment (4 hours at 1080°C), a thermal barrier coating (TBC) was first formed on the specimens by means of two successive deposits, both using the known plasma spray technique: first of all, the substrate (UD 520 superalloy) was applied directly with a so-called AMDRY 995 metal coating comprising cobalt, nickel, chromium, aluminium and yttrium in the following percentages of total weight: 38.5%, Co, 32% Ni, 21% Cr, 8% Al and 0.5% Y; and a coating of zirconium oxide stabilized with 8% by weight of yttrium oxide was then applied.

The powders and technique for plasma spraying metal and the ceramic coating are described in the work of F. Brossa and E. Lang: "Plasma Spraying - A Versatile Coating Technique" in W. Gissler, H. A. Jehn (eds.), "Advanced Techniques for Surface Engineering" (1992), 199-234, the content of which is incorporated herein as required for reference.

In the plasma spraying technique, the powders are (at least partially) melted by passage through a gas ionized and converted into plasma by an electric arc; the AMDRY 995 metal coatings are formed in a vacuum to a thickness of about 100-150 µm; and the yttrium-stabilized zirconium oxide coatings are formed in air to a thickness to about 150 µm.

### 2. Sealing coating: metallorganic chemical vapor deposition (MOCVD)

The thermal barrier coating was subsequently sealed with a silica (SiO₂) coating formed by metallorganic chemical vapor deposition (hereinafter referred to as MOCVD).

The sealing coating is deposited inside a horizontal-hot-wall reactor comprising a quartz tube heated by a conventional oven; and a liquid volatile metallorganic precursor - tetraethylorthosilicate, Si(OC₂H₅)₄, commonly known as TEOS - was used at ambient temperature.

The silica was deposited from the tetraethylorthosilicate precursor in the presence of oxygen and nitrogen, at 700°C, at a total pressure of 200 Pa, and with an oxygen (O₂) flow rate of 10 cm³/min; the precursor was fed into the reactor using an inert gas (more specifically, nitrogen, N₂) fed at a flow rate of 10 cm³/min through an evaporator maintained at 40°C; the nitrogen gas was also used as a diluting gas at a flow rate of 100 cm³/min; premature reaction of the oxygen and TEOS was prevented by keeping them separate up to the reaction region; and the deposition process was conducted in the above conditions for approximately one hour.

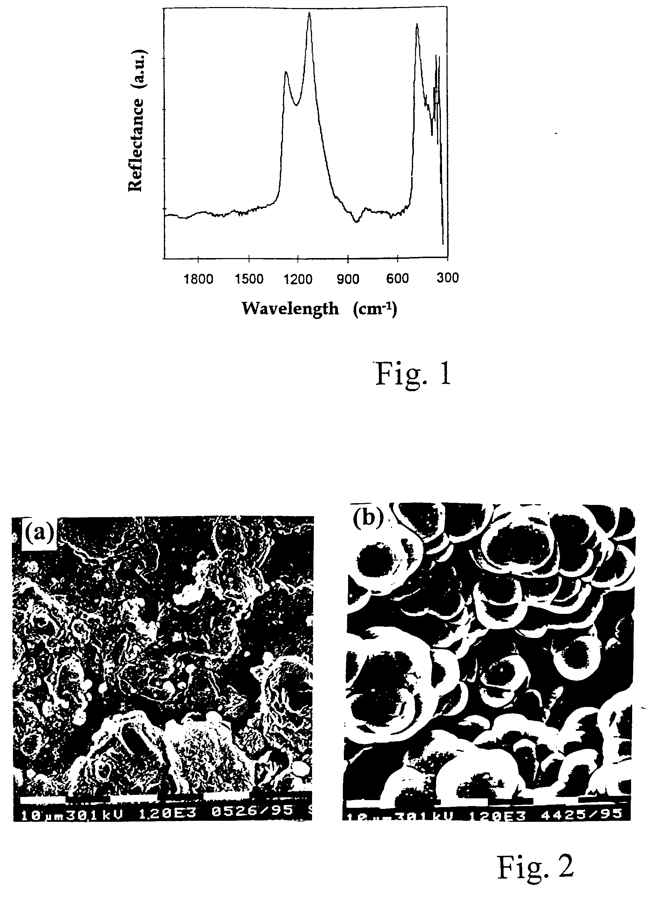

The resulting coating was then subjected to x-ray diffraction analysis, which showed no peaks characteristic of a crystallized coating, thus indicating most likely the presence of amorphous silica. To confirm both the presence of silica and its structure, the Fourier Transform Infrared (FTIR) method was applied: the resulting reflection spectrum (Figure 1) shows vibration bands comparable with those recorded in existing literature when applying the transmission technique to silica glass specimens. A comparison, also using the known Kramers-Kronig dispersion relation, shows a close match in the location of the peaks, thus enabling the reflection spectrum vibration bands to be assigned. More specifically (Figure 1), the CVD coating spectrum shows a pair of peaks (at roughly 1280 and 1140 cm⁻¹) associated with antisymmetric Si-O-Si vibration, and a band of about 490 cm⁻¹ associated with flexural vibration outside the Si-O-Si plane, so that the wave numbers are relatively high, typical of a totally vitrified silica coating.

The surface structure of the thermal barrier coatings before and after sealing with silica are shown in Figure 2: the silica coating is in the form of a homogeneous surface formed of numerous different diameter spheres.

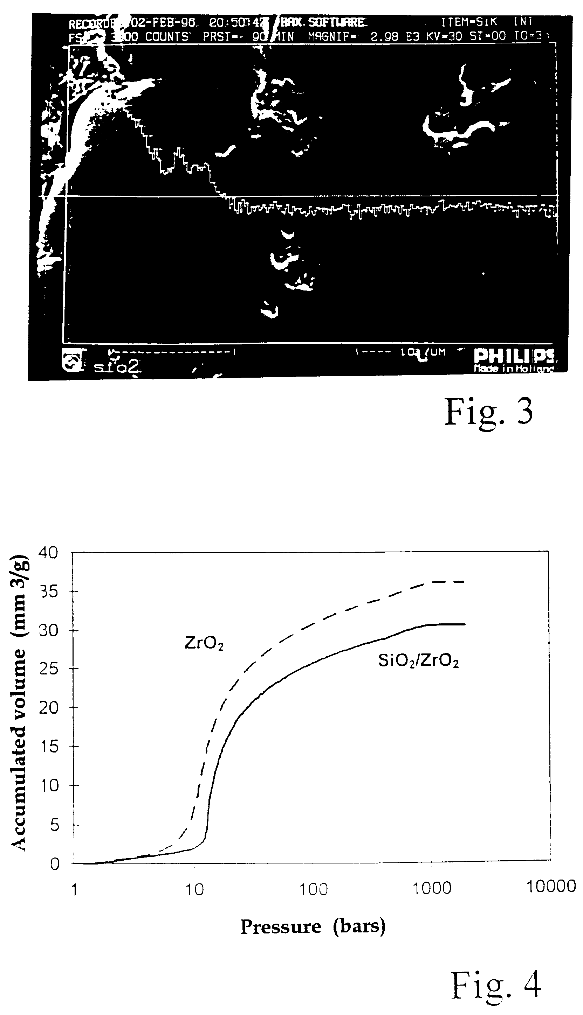

A cross section of the silica coating was also subjected to SEM-EDS chemical quality analysis: the silicon (Si) element was selected and its presence line-scanned up to the zirconium oxide interface. The structure and Si line-scan analysis of the cross section of a silica-coated specimen are shown in Figure 3, which shows a highly compact coating with a barely visible zirconium oxide interface.

### 3. Porosity measurements

Porosity was measured using a Carlo Erba Strumentazione 200 porosimeter at 1 to 2000 bar pressure.

As is known, porosity measurements are based on the ability of mercury to act as a non-wetting liquid with a wide range of solids, and therefore to penetrate the pores of a solid specimen under increasing pressure. The radius of the penetrated pores in inversely proportional to the pressure exerted, according to a relation proposed by Washburn.

By measuring the quantity of mercury penetrating the pores of the specimen, and the balance pressure at which the measurement is made, it is possible to calculate pore volume distribution as a function of the radius of the pores. The instrument also gives: mass density (g/cm³), apparent density (g/cm³) and percentage porosity (%).

Figure 4 shows the results of non-sealed zirconium oxide (dotted-line curve) and silica-coated zirconium oxide (continuous-line curve). The silica-coated zirconium oxide curve shows a smaller volume of mercury absorbed by the material, and hence a reduction in the overall porosity of the material.

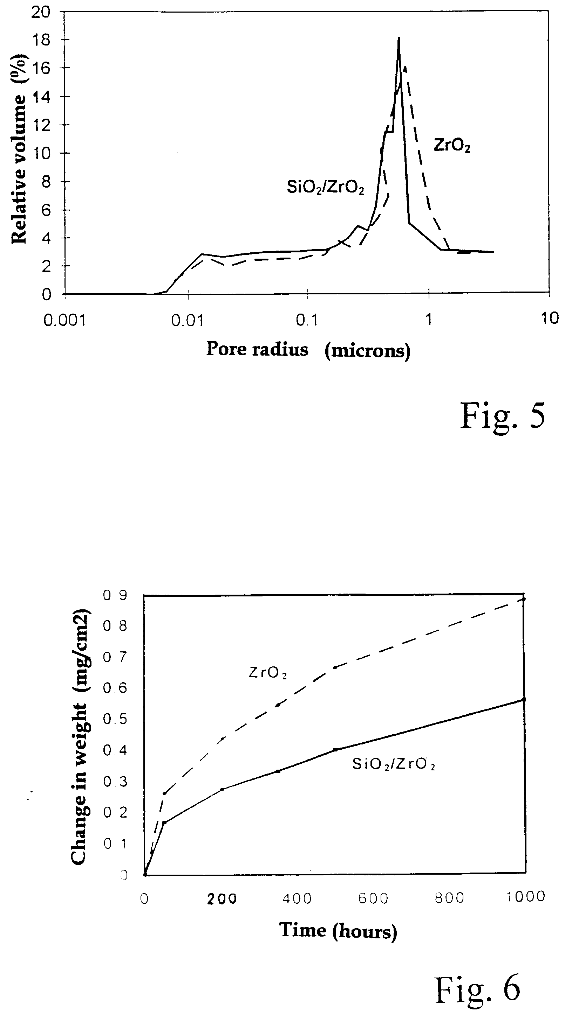

As shown in Figure 5 illustrating the size distribution of the pores, the reduction in overall porosity is related to the reduction in the average radius of the pores. Table 1 shows the overall findings, and confirms a roughly 16% reduction in the overall porosity of silica-coated zirconium oxide.

**TABLE 1**

| | Apparent density (g/cm³) | Mass density (g/cm³) | Percentage porosity (%) |
|---|---|---|---|
| Zirconium oxide | 5,09 | 6,23 | 18,4 |
| Zirconium oxide + SiO₂ | 5,01 | 5,92 | 15,4 |

### 4. Thermal barrier oxidation

To determine the effectiveness of the sealing coating in preventing oxidation of the metal layer of TBCs, the specimens were high-temperature oxidation tested, and the oxidation rate determined by the change in weight and by the thickness of the alumina layer formed during oxidation.

Testing was conducted in air at a temperature of 1000°C; the change in weight of the specimens was determined every 50 hours up to 250 hours, then every 250 hours up to 1000 hours. A comparison oxidation test was also made of non-sealed thermal barriers. The change in weight as a function of oxidation time is shown in Figure 6.

As shown in the Figure 6 graph, both with and without the sealing coating, the change in weight is more marked during the first 50 hours of oxidation, due, as is known, to the formation of a protective alumina layer. As oxidation continues, the sealed coatings, at least up to 1000 hours, show a roughly 35% smaller increase in weight as compared with the others. Metallographic sections made of both types of specimen after 1000 hours of oxidation also confirm a roughly 35% reduction in oxide thickness at the ceramic-metal interface.

In other words, the method according to the invention provides for sealing and greatly reducing the corrosion of thermal barrier coatings.

Clearly, changes may be made to the method as described and illustrated herein without, however, departing from the scope of the present invention.

## Claims

1. A method of sealing open-pore ceramic coatings, in particular thermal barrier coatings, the method comprising a deposition step wherein a sealer is deposited on the outer surface of said coatings; characterized in that said deposition step is performed by chemical vapor deposition (C.V.D.) of said sealer on said outer surface of said coatings; said chemical vapor deposition being so controlled as to limit the penetration depth of said sealer inside the pores of said coatings to a predetermined value.

2. A method as claimed in Claim 1, characterized in that said penetration depth of said sealer inside said pores ranges between approximately 10 µm and approximately 20 µm.

3. A method as claimed in Claim 1 or 2, characterized in that said chemical vapor deposition step is performed using a metallorganic precursor of said sealer.

4. A method as claimed in Claim 3, characterized in that said sealer is silicon dioxide (silica), SiO₂.

5. A method as claimed in Claim 4, characterized in that said metallorganic precursor of said sealer is tetraethylorthosilicate (TEOS), Si(OC₂H₅)₄.

6. A method as claimed in one of the foregoing Claims from 3 to 5, characterized in that said chemical vapor deposition step from said metallorganic precursor is performed in a horizontal-hot-wall reactor comprising at least one quartz tube heated by a conventional oven.

7. A method as claimed in Claim 6, characterized in that said chemical vapor deposition step is performed at a temperature of 700°C and at a total pressure of 200 Pa.

8. A method as claimed in Claim 6 or 7, characterized in that said chemical vapor deposition step is performed in the presence of oxygen and nitrogen.

9. A method as claimed in Claim 8, characterized in that said oxygen is fed into said reactor at a flow rate of 10 cm³/min, and said nitrogen is used partly as an inert gas to transport said metallorganic precursor at a flow rate of 10 cm³/min.

10. A method as claimed in Claim 9, characterized in that said nitrogen is also used partly as a diluting gas at a flow rate of 100 cm³/min.
